# EUROPÄISCHE PATENTSCHRIFT

(11) **EP 0 658 007 B1**
(45) Veröffentlichungstag und Bekanntmachung des Hinweises auf die Patenterteilung: **24.02.1999**
(21) Anmeldenummer: 94113258.1
(22) Anmeldetag: 25.08.1994
(51) Int. Cl.: H03M 3/02

(54) **Schaltungsanordnung zur Analog/Digital-Wandlung von frequenzmodulierten Zwischenfrequenzsignalen**
Circuit for the analog-digital conversion of IF-signals
Circuit pour la conversion analogue-numérique des signaux de fréquence intermédiaire modulé de fréquence

(30) Priorität: 10.12.1993 DE 4342145
(43) Veröffentlichungstag der Anmeldung: 14.06.1995
(73) Patentinhaber: Blaupunkt-Werke GmbH, 31132 Hildesheim (DE)
(72) Erfinder: Chahabadi, Djahanyar, Dr., D-23909 Ratzeburg (DE)

(56) Entgegenhaltungen:
- DE-A- 3 212 054
- DE-A- 4 104 882
- GB-A- 2 233 518
- US-A- 4 888 557
- US-A- 4 902 979
- US-A- 5 075 679
- US-A- 5 150 120

## Beschreibung

Die Erfindung geht aus von einer Schaltungsanordnung nach der Gattung des Hauptanspruchs.

Aus A. M. Thurston: "Bandpass Implementation of the Sigma-Delta-A-D Conversion Technique", Seiten 81 bis 86, ist eine Schaltungsanordnung zur Analog/Digital-Wandlung von frequenzmodulierten Zwischenfrequenzsignalen und deren Herabsetzung ins Basisband bekanntgeworden, bei der zunächst eine Analog/Digital-Wandlung und anschließend durch Mischung mit zwei Quadraturkomponenten eines Mischsignals eine Herabsetzung ins Basisband erfolgt. Zur Analog/Digital-Wandlung wird dabei ein Bandpaß-Sigma-Delta-Wandler benutzt. Dabei bereitet die Realisierung eines Bandpasses mit engen Toleranzen bezüglich der Mittenfrequenz bei den durch die Zwischenfrequenz bedingten hohen Frequenzen Schwierigkeiten und kann darüberhinaus zu Stabilitätsproblemen führen.

Aufgabe der vorliegenden Erfindung ist es, eine Schaltungsanordnung zur Analog/Digital-Wandlung von frequenzmodulierten Zwischenfrequenzsignalen und zu deren Herabsetzung ins Basisband anzugeben, welche nicht so hohe Anforderung an die Genauigkeit einzelner Bauteile stellt.

Diese Aufgabe wird erfindungsgemäß mit den im kennzeichnenden Teil des Patentanspruchs 1 angegebenen Merkmalen erfüllt. Dabei ist außer der einfachen Realisierbarkeit von Vorteil, daß der im Analogteil der Schaltungsanordnung entstehende Offset unterdrückt wird und somit nicht mehr - beispielsweise durch einen erhöhten Klirrfaktor - im demodulierten Signal störend in Erscheinung tritt.

Vorteilhaft für eine anschließende Herabsetzung der Abtastrate auf einen für eine weitere Verarbeitung günstigen Wert ist, daß zunächst die Abtastrate der Ausgangssignale der Mischer verdoppelt wird. Dabei ist günstig, wenn die Verdoppelung der Abtastrate durch Einfügen von Nullen und anschließende Tiefpaßfilterung erfolgt.

Eine vorteilhafte Ausgestaltung der erfindungsgemäßen Schaltungsanordnung besteht darin, daß die Mischer eine Multiplikation der Abtastwerte der Ausgangssignale der Hochpaß-Sigma-Delta-Wandler abwechselnd mit +1 und -1 durchführen. Dadurch ist eine besonders einfache Realisierung der Mischer möglich.

Wie auch bei der bekannten Schaltungsanordnung kann bei der erfindungsgemäßen Schaltungsanordnung vorgesehen sein, daß die Abtastrate dem Doppelten der Zwischenfrequenz entspricht. Außerdem können Hochpaß-Sigma-Delta-Wandler erster oder zweiter Ordnung verwendet werden.

Ausführungsbeispiele der Erfindung sind in der Zeichnung anhand mehrerer Figuren dargestellt und in der nachfolgenden Beschreibung näher erläutert. Es zeigt:
- Fig. 1: ein Blockschaltbild einer erfindungsgemäßen Schaltungsanordnung,
- Fig. 2: Impulsdiagramme einiger bei der Schaltungsanordnung nach Fig. 1 verwendeter Taktsignale,
- Fig. 3: ein Beispiel für einen in der Schaltungsanordnung nach Fig. 1 vorgesehenen Hochpaß-Sigma-Delta-Wandler,
- Fig. 4: ein weiteres Beispiel eines weiteren Hochpaß-Sigma-Delta-Wandlers und
- Fig. 5: ein Frequenzspektrum des Ausgangssignals eines der Hochpaß-Sigma-Delta-Wandler.

Gleiche Teile sind in den Figuren mit gleichen Bezugszeichen versehen. Das Ausführungsbeispiel sowie Teile davon sind zwar als Blockschaltbilder dargestellt. Dieses bedeutet jedoch nicht, daß die erfindungsgemäße Schaltungsanordnung auf eine Realisierung mit Hilfe von einzelnen den Blöcken entsprechenden Schaltungen beschränkt ist. Die erfindungsgemäße Schaltungsanordnung ist vielmehr in besonders vorteilhafter Weise mit Hilfe von hochintegrierten Schaltungen realisierbar. Dabei kann beispielsweise ein digitaler Signalprozessor eingesetzt werden, welcher bei geeigneter Programmierung die im Blockschaltbild dargestellten Verarbeitungsschritte durchführt. Die erfindungsgemäße Schaltungsanordnung kann zusammen mit weiteren Schaltungsanordnungen innerhalb einer integrierten Schaltung wesentliche Teile eines Rundfunkempfängers bilden.

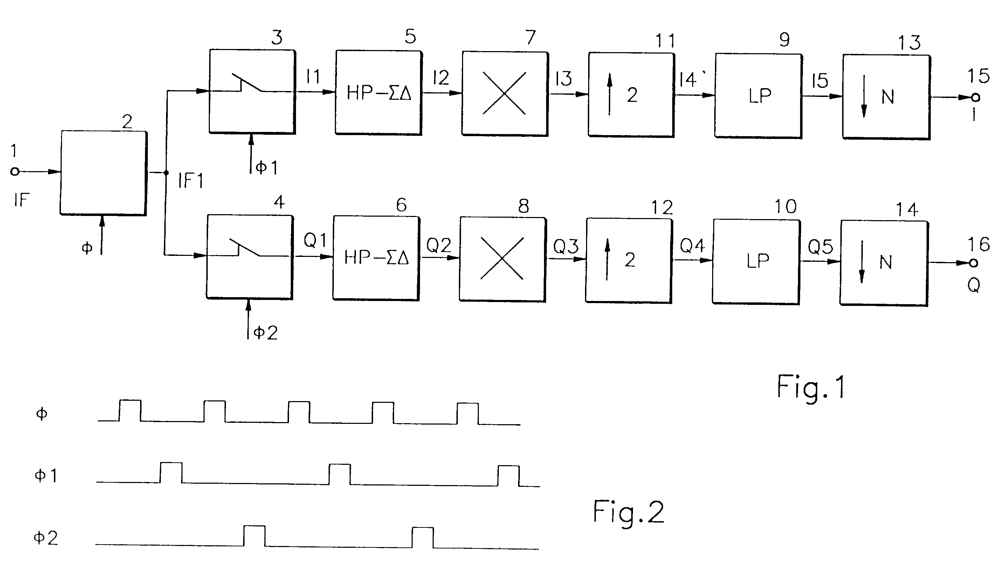

Bei der Schaltungsanordnung nach Fig. 1 wird ein Zwischenfrequenzsignal IF über einen Eingang 1 einer Abtast- und Halteschaltung 2 zugeführt, welche das Zwischenfrequenzsignal IF mit einem Takt Φ abtastet. Die Frequenz des Taktsignals Φ beträgt das Zweifache der Zwischenfrequenz, also 21,4 MHz und ist in Fig. 2 dargestellt. Das durch die Abtastung und Haltung entstandene Zwischenfrequenzsignal IF1 ist zwar zeitdiskret, es behält also seinen Wert zwischen zwei Abtastzeitpunkten bei, es ist jedoch wertkontinuierlich. Dieses Signal wird zwei steuerbaren Schaltern 3, 4 zugeleitet, welche mit Taktsignalen Φ1 und Φ2 angesteuert sind, welche jeweils die halbe Frequenz des Taktsignals Φ aufweisen und zueinander um eine Periodendauer des Taktes Φ versetzt sind (Fig. 2).

Dadurch werden die Abtastwerte des Signals IF1 bzw. des Signals IF als Signale I1 und Q1 abwechselnd jeweils einem der beiden Hochpaß-Sigma-Delta-Wandler 5, 6 zugeleitet. In an sich bekannter Weise entstehen dort digitale Signale I2, Q2, welche anschließend in Mischern 7, 8 in das Basisband herabgesetzt werden. Die Mischung erfolgt mit Mischsignalen der ZF-Frequenz, welche als Folge +1, -1, +1, -1 usw. dargestellt sind. Die Ausgangssignale I3 und Q3 der Mischer 7, 8 liegen somit im Basisband. Ein im Analogteil der Schaltung, das heißt, vor den Sigma-Delta-Wandlern bzw. in einem Analogteil der Sigma-Delta-Wandler hinzugefügter Offset wird auf die Zwischenfrequenz hochgemischt, die bei einer anschließenden Tiefpaßfilterung unterdrückt wird.

Vor der Tiefpaßfilterung bei 9, 10 wird jedoch die Abtastrate der Signale I3 und Q3 bei 11, 12 verdoppelt. Dieses geschieht in einfacher Weise dadurch, daß zwischen jeweils zwei Abtastwerten ein Wert 0 eingefügt wird. Für die Signale I4 und Q4 ergibt sich dann:
I4(m) = I3(n) für m = 2n; = 0 für m = 2n+1
Q4(m) = 0 für m = 2n; = Q3(n) für m = 2n+1

Dabei bedeuten m und n Zähler der Abtastungen der Signale I4 und Q4 bzw. I3 und Q3.

An den Ausgängen der Tiefpaßfilter 9, 10 stehen die Signale I5 und Q5 als Basisbandsignale zur Verfügung. Sie weisen allerdings eine im Verhältnis zu ihrer Bandbreite sehr hohe Abtastrate auf. Da bei einer anschließenden weiteren Verarbeitung aus Aufwandsgründen eine an die Bandbreite angepaßte Abtastrate vorteilhaft ist, sind Schaltungen 13, 14 zur Dezimierung der Abtastrate um einen Teiler N vorgesehen, an deren Ausgängen 15, 16 die Signale I und Q entnommen werden. Außerdem wird durch Tiefpaß-Filterung der Signal-Rausch-Abstand erhöht.

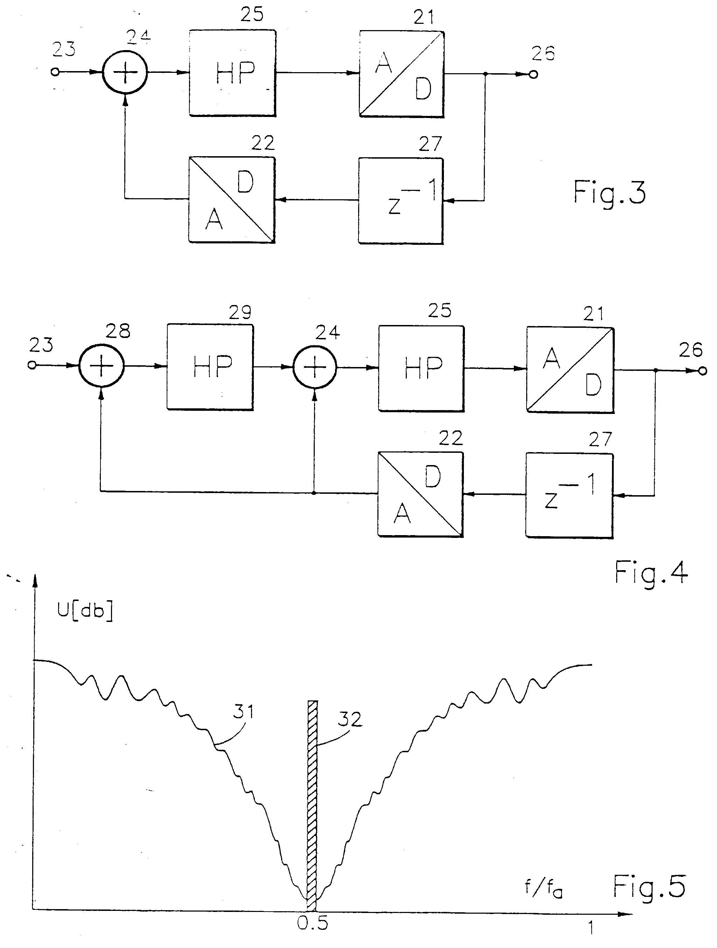

Bei dem in Fig. 3 dargestellten Beispiel eines Hochpaß-Sigma-Delta-Wandlers sind ein Analog/Digital-Wandler 21 und ein Digital/Analog-Wandler 22 vorgesehen. Das zu wandelnde zeitdiskrete und wertkontinuierliche Signal wird bei 23 zugeführt und bei 24 zum rückgeführten digital/analog-gewandelten Signal hinzuaddiert. Die Summe wird über einen Hochpaß erster Ordnung 25 dem Analog/Digital-Wandler 21 zugeleitet, an dessen Ausgang 26 das digitale Signal abgenommen werden kann. Ebenfalls vom Ausgang 26 des Analog/Digital-Wandlers 21 wird das zurückzuführende digitale Signal entnommen und über eine Verzögerung 27 um eine Abtastperiode dem Eingang des Digital/Analog-Wandlers 22 zugeführt.

Der in Fig. 4 dargestellte Hochpaß-Sigma-Delta-Wandler zweiter Ordnung enthält außer den bereits im Zusammenhang mit Fig. 3 erläuterten Teilen einen weiteren Addierer 28 und einen weiteren Hochpaß erster Ordnung 29. Die Hochpässe 25, 29 weisen übrigens eine Übertragungsfunktion von 1/(1+v·z⁻¹) auf.

Fig. 5 zeigt das Spektrum des Ausgangssignals der Hochpaß-Sigma-Delta-Wandler 5, 6 (Fig. 1), wobei die Frequenz auf die Abtastrate, das heißt, auf die Frequenz des Taktes Φ normiert ist. Das Quantisierungsrauschen 31 hat ein ausgeprägtes Minimum bei f = 0,5·fₐ . Im Bereich dieses Minimums befindet sich das Spektrum 32 des Nutzsignals, so daß nach Umsetzung in das Basisband und Tiefpaßfilterung praktisch kein Quantisierungsrauschen im Nutzsignal verbleibt.

## Patentansprüche

1. Schaltungsanordnung zur Analog/Digital-Wandlung von frequenzmodulierten Zwischenfrequenzsignalen und zu deren Herabsetzung ins Basisband, dadurch gekennzeichnet,
- daß die Zwischenfrequenzsignale einer Abtast- und Halteschaltung (2) zuführbar sind, welche die Zwischenfrequenzsignale mit einer gegebenen Abtastrate abtastet,
- daß an die Abtast- und Halteschaltung (2) zwei Hochpaß-Sigma-Delta-Wandler (5, 6) angeschlossen sind, denen die von der Abtast- und Halteschaltung (2) abgeleiteten Abtastwerte abwechselnd zugeführt werden, und
- daß Ausgänge der Hochpaß-Sigma-Delta-Wandler (5, 6) mit Mischern (7, 8) verbunden sind, welchen Mischsignale mit einer Frequenz von einem Halben der Abtastrate zugeführt werden.

2. Schaltungsanordnung nach Anspruch 1, dadurch gekennzeichnet, daß die Abtastrate der Ausgangssignale der Mischer (7, 8) verdoppelt wird.

3. Schaltungsanordnung nach Anspruch 2, dadurch gekennzeichnet, daß die Verdoppelung der Abtastrate durch Einfügen von Nullen und anschließende Tiefpaßfilerung erfolgt.

4. Schaltungsanordnung nach einem der Ansprüche 2 oder 3, dadurch gekennzeichnet, daß ferner eine Herabsetzung auf eine für eine weitere Verarbeitung günstige Abtastrate erfolgt.

5. Schaltungsanordnung nach einem der vorhergehenden Ansprüche, dadurch gekennzeichnet, daß die Mischer (7, 8) eine Multiplikation der Abtastwerte der Ausgangssignale der Hochpaß-Sigma-Delta-Wandler (5, 6) abwechselnd mit +1 und -1 durchführen.

6. Schaltungsanordnung nach einem der vorhergehenden Ansprüche, dadurch gekennzeichnet, daß die Abtastrate dem Doppelten der Zwischenfrequenz entspricht.

7. Schaltungsanordnung nach einem der vorhergehenden Ansprüche, dadurch gekennzeichnet, daß Hochpaß-Sigma-Delta-Wandler erster Ordnung vorgesehen sind.

8. Schaltungsanordnung nach einem der Ansprüche 1 bis 6, dadurch gekennzeichnet, daß Hochpaß-Sigma-Delta-Wandler zweiter Ordnung vorgesehen sind.

## Claims

1. Circuit arrangement for the analogue/digital conversion of frequency-modulated intermediate frequency signals and for the reduction thereof into the baseband, characterized
- in that the intermediate frequency signals can be fed to a sample-and-hold circuit (2) which samples the intermediate frequency signals at a given sampling rate,
- in that two high-pass sigma-delta converters (5, 6) are connected to the sample-and-hold circuit (2), the samples derived from the sample-and-hold circuit (2) being fed alternately to the said high-pass sigma-delta converters, and
- in that outputs of the high-pass sigma-delta converters (5, 6) are connected to mixers (7, 8), to which mixing signals are fed at a frequency of one half of the sampling rate.

2. Circuit arrangement according to Claim 1, characterized in that the sampling rate of the output signals of the mixers (7, 8) is doubled.

3. Circuit arrangement according to Claim 2, characterized in that the sampling rate is doubled by the insertion of zeros and subsequent low-pass filtering.

4. Circuit arrangement according to either of Claims 2 and 3, characterized in that a reduction to a sampling rate which is favourable for further processing is furthermore effected.

5. Circuit arrangement according to one of the preceding Claims, characterized in that the mixers (7, 8) carry out a multiplication of the samples of the output signals of the high-pass sigma-delta converters (5, 6) alternately by +1 and -1.

6. Circuit arrangement according to one of the preceding Claims, characterized in that the sampling rate corresponds to twice the intermediate frequency.

7. Circuit arrangement according to one of the preceding Claims, characterized in that first-order high-pass sigma-delta converters are provided.

8. Circuit arrangement according to one of Claims 1 to 6, characterized in that second-order high-pass sigma-delta converters are provided.

## Revendications

1. Circuit de conversion analogique/numérique de signaux de fréquence intermédiaire, modulés en fréquence et pour les rabaisser dans la bande de base,
caractérisé en ce qu'
- on applique les signaux de fréquence intermédiaire d'un circuit de détection et de maintien (2) qui détecte les signaux de fréquence intermédiaire avec un coefficient de détection donné,
- on relie deux convertisseurs sigma/Delta passe-haut (5, 6) au circuit de détection et de maintien et on applique en alternance à ces deux convertisseurs les valeurs de détection déduites du circuit de détection et de maintien (2), et
- on relie les sorties des convertisseurs Sigma/Delta passe-haut (5, 6) à des mélangeurs (7, 8) fournissant des signaux de mélange d'une fréquence correspondant à la moitié de la fréquence de détection.

2. Circuit selon la revendication 1,
caractérisé en ce que
le taux de détection des signaux de sortie des mélangeurs (7, 8) est doublé.

3. Circuit selon la revendication 1,
caractérisé en ce que
le doublage du taux de détection se fait par insertion d'état zéros, puis filtrage consécutif par un filtre passe-bas.

4. Circuit selon l'une des revendications 2 ou 3,
caractérisé en ce qu'
en outre on réduit un taux de détection avantageux pour la suite du traitement.

5. Circuit selon l'une quelque des revendications,
caractérisé en ce que
les mélangeurs (7, 8) effectuent une multiplication des valeurs de détection des signaux de sortie des convertisseurs Sigma/Delta passe-haut (5, 6), en alternance par +1 et -1.

6. circuit selon l'une quelconque des revendications,
caractérisé en ce que
le taux de détection correspond au double de la fréquence intermédiaire.

7. Circuit selon l'une quelconque des revendications,
caractérisé en ce que
le convertisseur Sigma/Delta passe-haut est du premier ordre.

8. Circuit selon l'une quelconque des revendications 1 à 6,
caractérisé en ce que
le convertisseur Delta/Sigma passe haut est du second ordre.
